(19) Europäisches Patentamt / European Patent Office / Office européen des brevets

(11) **EP 2 898 418 B1**

(12) **EUROPEAN PATENT SPECIFICATION**

(45) Date of publication and mention
of the grant of the patent:
**16.08.2017 Bulletin 2017/33**

(21) Application number: **13715393.8**

(22) Date of filing: **28.02.2013**

(51) Int Cl.:
*G06F 13/42* *(2006.01)*    *G01R 19/25* *(2006.01)*

(86) International application number:
**PCT/GB2013/050509**

(87) International publication number:
**WO 2014/045005 (27.03.2014 Gazette 2014/13)**

(54) **BRANCH CIRCUIT MONITORING**

ÜBERWACHUNG EINER VERZWEIGUNGSSCHALTUNG

SURVEILLANCE DE CIRCUITS DE DÉRIVATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **20.09.2012 GB 201216823**

(43) Date of publication of application:
**29.07.2015 Bulletin 2015/31**

(73) Proprietor: **Tyrrell Products Limited
Leigh, Lancashire WN7 1AY (GB)**

(72) Inventors:
• **TYRRELL, Gerard Anthony
Leigh
Lancashire WN7 4HW (GB)**
• **MURRAY, Gerrard James
Glasgow G67 4QH (GB)**

(74) Representative: **Cozens, Paul Dennis et al
Mathys & Squire LLP
The Shard
32 London Bridge Street
London SE1 9SG (GB)**

(56) References cited:
**WO-A1-03/041029     WO-A2-2007/063482**

## Description

The present invention relates to branch circuit monitoring, and in particular to a method of synchronising measurement modules, for the purpose of accurate voltage based measurements.

WO03/041029A relates to a measurement module and control unit; and WO2007063482 relates to a bus station and system and method of maintaining synchronizing of a bus station.

Summary of the invention.

A first aspect of the the invention is a method as defined in independent claim 1. A second aspect of the invention is a system as defined in independent claim 13. Third and fourth aspects of the invention are measurement modules as defined in independent claim 14 and 15, respectively. Further embodiments of the invention are specified in the appended dependent clams.

These and other aspects of the present invention will become apparent from the following exemplary embodiments that are described with reference to the following figures in which:

Figure 1 is an illustration of a branch circuit monitor;
Figure 2 is an illustration of a modular branch circuit monitor;
Figure 3a is a top view of modular branch circuit monitors;
Figure 3b is a side view of modular branch circuit monitors;
Figures 4a and 4b are top views of modular branch circuit monitors with alternative layouts;

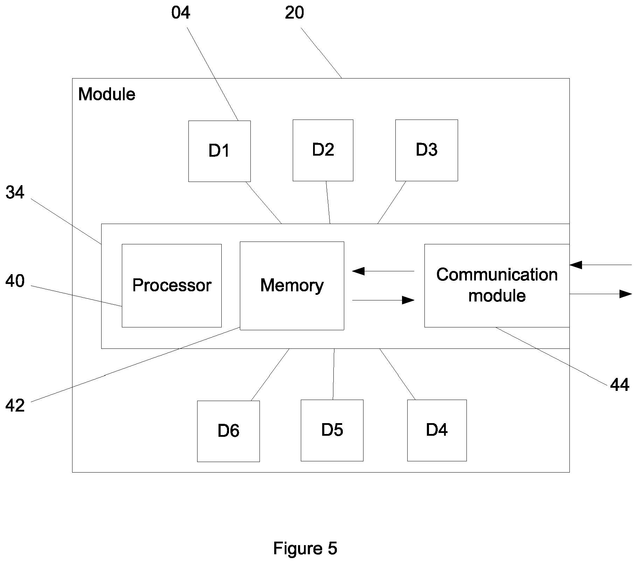

Figure 5 is a schematic diagram of a modular branch circuit monitor;
Figure 6 is an illustration of a modular branch circuit monitor with split core detectors;
Figure 7 is an illustration of a first example of a modular voltage monitor;
Figure 8 is an illustration of a second example of a modular voltage monitor;
Figure 9 is a flow diagram of the synchronisation;
Figure 10 is a schematic diagram of the synchronisation; and
Figure 11 is a schematic diagram illustrating the measurement error within a zero crossing detector circuit.

Branch circuit monitors allow monitoring of branches of an electrical circuit. A monitor typically determines for a number of branch circuits the current, voltage, energy and/or power consumption relating to each branch. Knowledge of the consumption of each branch permits operations such as the allocation of costs to a branch based on usage; protection from overloading at individual branches; and management of the load distribution between different branches.

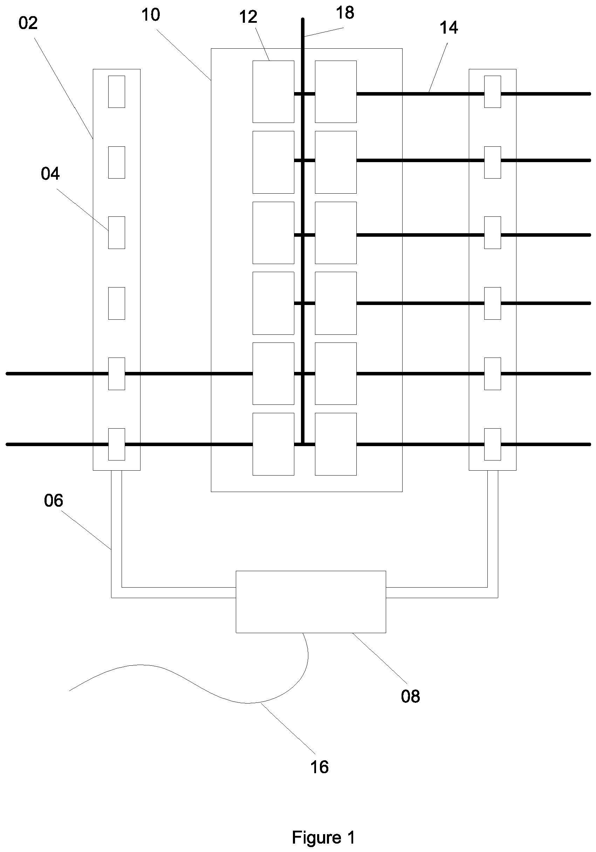

Figure 1 shows an example of an electrical distribution board 10 (also known as circuit breaker box or panel box) with a main power line 18. The power is distributed by power distribution units 12 to a number of branch circuits 14. A branch circuit monitor 02 comprises a number of detectors 04, typically solid core current transducers, each of which is capable of monitoring a branch circuit 14. The branch circuit monitor 02 passes signals from the detectors 04 via a ribbon cable 06 on to a data acquisition board 08, where the data from the detectors 04 is processed. The processed data is passed further via a communication link 16 (for example using the Modbus communication protocol) to a controller or a computing device for storage, display and evaluation of the data; optionally, the communication link 16 may pass via a one or more further data acquisition boards (for a daisy-chain arrangement of data acquisition boards, if desired).

Solid core current transducers as detectors 04 have the advantage of higher accuracy. Solid core current transducers as detectors 04 are mounted on a branch circuit monitor 02 (typically on a printed circuit board) at a pitch which corresponds to the pitch of the branch circuits 14 in the distribution board 10.

Instead of solid core current transducers, split core current transducers may be used. Split core current transducers allow opening and closing of the core so as to enclose a circuit connection. This is necessary for example if the detector is to be fitted to an existing circuit connection, in which case the detector can be installed without interrupting the circuit.

The above system presents several shortcomings. Passing the analogue detector data from the current transducers 04 via a ribbon cable 06 (or any other cable) on to a data acquisition board 08 introduces electrical noise due to the cable. The analogue signal from the detector can be relatively low and subject to a relatively high signal-to-noise ratio. Electrical interference to which the analogue signal is subjected en route to the data acquisition board 08 can degrade the signal. For highly accurate measurement it is preferable to minimise cabling. Further, the branch circuit monitor 02 typically comprises tens of detectors 04. If, as in the illustrated example, only a subset of the power distribution units 12 have a branch circuit 14, then some (or even many) of the detectors 04 are superfluous.

The shortcomings of the above system are overcome by a system with modular branch circuit monitors with on-board signal processing. As referred to herein, a module is a self-contained unit that is connectable to another such module (or to a different type of module), the modules (of whatever type) having a common communication link.

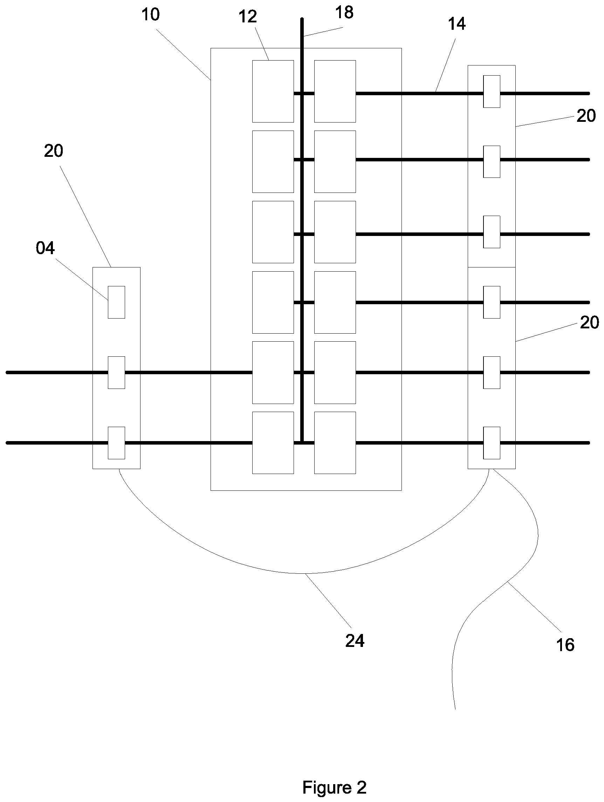

Figure 2 shows an alternative electrical distribution board 10 (or circuit breaker box) with modular branch circuit monitors 20 with on-board signal processing (like reference numerals denote like components). Each modular branch circuit monitor includes a number of detectors 04. Modular branch circuit monitors 20 may be physically linked or attached to one another by a connection to form a composite branch circuit monitor with the appropriate number of detectors 04 for a given number of branch circuits 14. As seen in Figure 2, the number of modular branch circuit monitors 20 in a composite branch circuit monitor can be chosen to minimise the superfluous detectors 04: on the left of the distribution board there are only two branch circuits 14, and a single three-detector module 20 is sufficient. On the right there are six branch circuits 14, and two three-detector modules 20 are connected to form a composite six-detector monitor.

To enable freedom in the choice of connection of modules, each module 20 includes means for processing (at the module itself) the analogue signal detected by the detectors 04 to produce digital output data. This ensures that operation of a composite monitor is independent of the number of modules forming the composite monitor. To achieve processing at the module 20, the module may be provided in the form of a printed circuit board on which are mounted detectors as well as components for signal processing (including analogue and/or digital processing and/or A/D conversion), and/or components for other functions (such as communication).

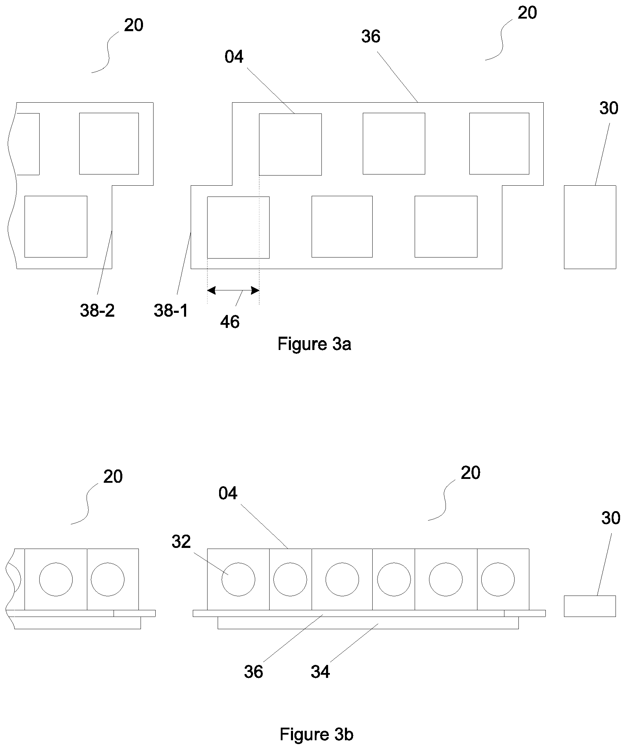

Figures 3a (top view), 3b (side view) and 5 (schematic diagram) show modular branch circuit monitors 20 with detectors 04 as well as further components 34 mounted on a printed circuit board 36. The further components are mounted on the opposite side from the detectors 04 on the printed circuit board 34 for compactness and space-efficiency; if compactness is not important, then some or all of the components 34 can be mounted on the same side as the detectors 04.

The components 34 include a processor 40 and a memory 42 to provide processing capability. Processing in particular includes conversion of analogue measurement data into digital data that can be communicated via a digital communication link (in the described example the Modbus link). A communication module 44 provides an interface to the communication link.

By enabling on-board localised processing of measurement data, electrical noise associated with cabling is minimised and the accuracy of the system is improved.

A terminal unit 30 may be designed to attach to a modular branch circuit monitor 20; if two or more modular branch circuit monitors are serially connected, one to the next, then the terminal unit 30 is attached to the end-most module. The terminal unit provides a connection to other components such a system interface, controller or a computing device for storage, display and evaluation of the data.

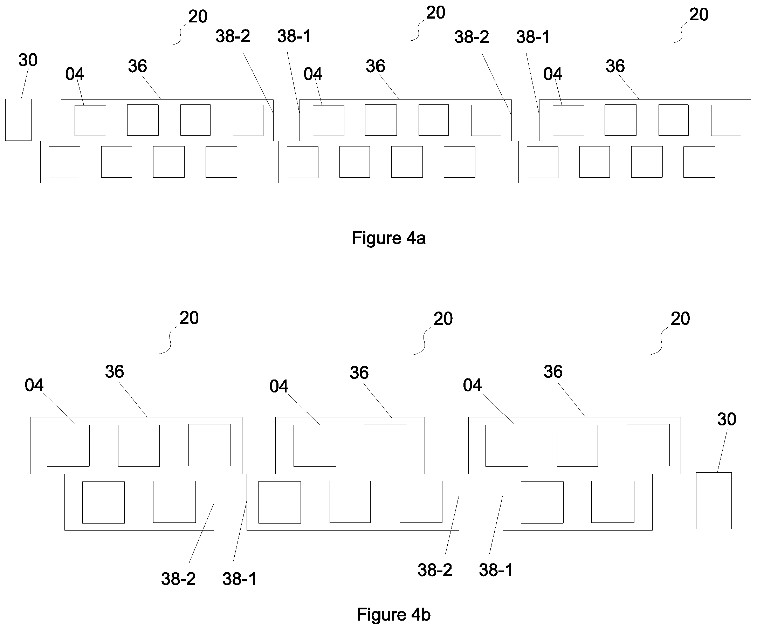

The number of detectors 04 per modular branch circuit monitor 20 may vary depending on requirements. In Figure 2 an example is illustrated with three detectors 04 per modular branch circuit monitor 20. In Figures 3a and 3b an example with six detectors 04 per modular branch circuit monitor 20 is shown. In Figure 4a an example with eight detectors 04 per modular branch circuit monitor 20 is shown. In Figure 4b an example with five detectors 04 per modular branch circuit monitor 20 is shown. Modules with different numbers of detectors may also be combined.

The detectors 04 on a modular branch circuit monitor 20 are mounted at a pitch which corresponds to the pitch of (or in other words the spacing between) the branch circuits on the distribution board the modular branch circuit monitor 20 is intended for use with. In the examples illustrated in Figures 3a to 4b, the detector width is wider than the branch circuit pitch, and the detectors are arranged in two rows. The detectors in a first row are offset against the detectors in the second row by an offset distance 46. This staggered detector arrangement allows a branch circuit pitch that is less than the detector width.

The detectors 04 on a modular branch circuit monitor 20 are shown to be solid core current transducers. In one example, the detectors are self-powered solid core transducers. While these detectors require no power supply and are relatively inexpensive, they can exhibit relatively low accuracy in detecting low currents. In another example the detectors are powered solid core transducers, such as Hall Effect transducers. Although these detectors require a power supply, they provide current measurements that are more accurate than their self-powered equivalent. The provision of more accurate measurements enables more detailed analysis of the current signal. For example harmonic analysis can evaluate the wave form to establish whether the current drawn by the load is linear or not. This can be important in identifying loads that are affecting the supply power quality, or to sense power supply fluctuations which might be indicative of failure.

A connector portion 38-1 of each modular branch circuit monitor 20 can be connected to a connector portion 38-2 of a neighbouring such modular branch circuit monitor 20. The connector portions 38-1 38-2 establish an electrical as well as a mechanical connection between the modular branch circuit monitors 20. The electrical connection can enable a serial connection of the modules, which can provide a convenient route for communication. The mechanical connection can enable formation of a composite unit comprising a plurality of modular branch circuit monitors 20. To form a composite unit, the connector portions 38-1 38-2 in the examples illustrated in Figures 3a to 4b comprise a tessellation feature that is capable of tessellation with a further such branch circuit monitor module. The tessellation feature is not only advantageous for establishing a mechanical connection; it can also permit modules with the staggered detector arrangement described above to be combined to form a composite unit. In the illustrated examples the tessellation feature is a step shape for simplicity and convenience regarding the staggered detector arrangement. Other tessellation shapes can be used. The connector portions 38-1 38-2 can include pins and sockets, clips, and other fixation features. For protection of male connector parts such as pins, the location in a recessed area of connector portions (such as connector portions 38-1 in Figure 4a) is particularly suitable; corresponding female connector parts can be located in a projecting area of the connector portions (such as connector portions 38-2 in Figure 4a).

In a preferred embodiment, the modular branch circuit monitors 20 are connected in series via a communications link, for example a Modbus link. In normal operation a modular branch circuit monitor 20 routes communications to the system interface via the other modular branch circuit monitors. A modular branch circuit monitor issues a communication onto the Modbus line; the Modbus line passes from one monitor to the next, until the terminal unit 30 at the end of a series of monitors. At the terminal unit 30 the Modbus line continues on via a communication link 16 to the system interface. The communications are digital, not analogue. If necessary the modules may address one another, but generally the modules communicate with the system interface.

One example where the modules communicate with one another is when the modules are being powered up. When the modules are serially connected in a daisy-chain arrangement, and are all powered up at once, the power source to the modules is required to supply more power than during normal usage. This necessitates selection of a power supply of higher performance than is required during usual operation. In order to overcome this drawback, the modules are preferably powered up sequentially. An end module, for example the module with the terminal unit, powers up first; once it is ready for operation, it issues a signal to its neighbouring module, which then commences to power up, and so on. In one example the signal is a digital signal transmitted via the common Modbus link, in which case addressing information for the neighbouring module is included. Alternatively there is a link between neighbours that is private between the two neighbouring modules; in this case no addressing information is required. The signal in this case can be digital or analogue.

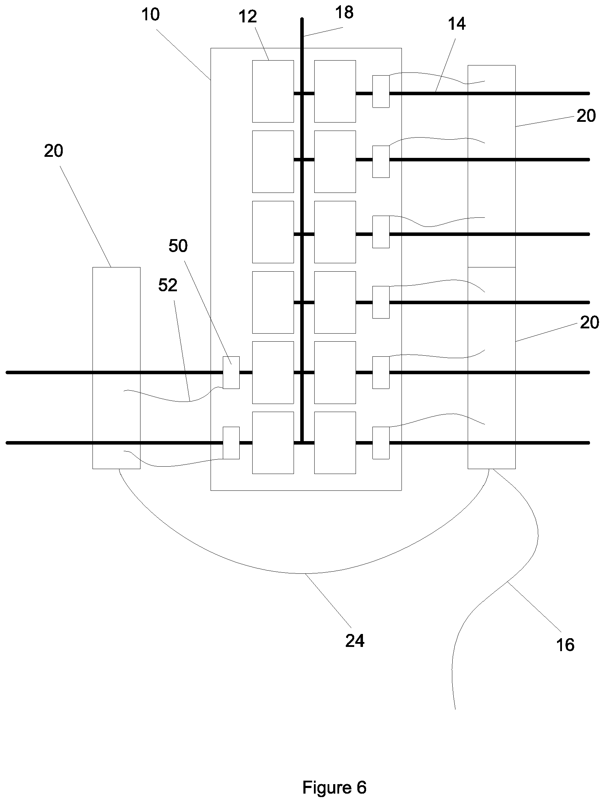

Figure 6 shows modular branch circuit monitors 20 with split core detectors 50. The split core detectors 50 are in this example connected to the modular branch circuit monitors 20 by a cable 52. The cable 52 carries the analogue detector data to the modular branch circuit monitors 20 for processing (including digitising). Subsequent operation is the same as for the modular branch circuit monitors 20 with solid core detectors 04. Split core current transducers are generally of a self-powered type.

As mentioned above, split core current transducers provide the advantage of enabling retrofitting of detectors. The analogue signal transmitted from the detectors 50 to the modules can suffer degradation due to electrical interference in the cable 52. So although some noise may be introduced, the signal is nevertheless not transmitted in its analogue form from the branch circuit monitor to a data acquisition board (as in the system described with reference to Figure 1). Minimising the distance the signal travels in its analogue form can reduce the noise incurred. Further, the number of modules can be selected depending on requirements, as with the solid core modules. The use of the modular branch circuit monitors hence provides the same advantages for use with split core detectors as it does with solid core detectors. Modules with split core detectors can also be combined with modules with solid core detectors.

An example of a modular branch circuit monitor design is now described in more detail.

In this example, communication between modules and the controller is provided via the Modbus protocol.

To provide power to the modular branch circuit monitor, in the embodiment described here the modular branch circuit monitor operates from a nominal +24 Volts supply (on- or off-board). The supply voltage input can range from +18.6 Volts to +36.6 Volts without compromising operation. For a configuration with six solid core current transducers (as shown in Figures 3a and 3b) the current consumption at +24 Volts input is 103mA. There are four power rails on the board derived from the incoming 24 Volt supply. The four power rails carry voltages of +24 Volts, +5 Volts, +15 Volts and -15 Volts from three DC-DC converters. Microcontroller and level shifting and filtering circuits are powered by a 3.3 Volts supply derived from the +5 Volts line. If split core current transducers are used instead of solid core current transducers the current consumption at +24 Volts input is 30mA, and +15 Volts and -15 Volts power lines can be omitted.

Each of the detection channels (six for the six-detector arrangement shown in Figures 3a and 3b) of the modular branch circuit monitor is scanned sequentially in a 'round robin' order. Each channel is measured in order and when the last channel has been measured, the board immediately returns to the first again. There is a short gap of approximately 3 milliseconds after a new channel is switched to. This allows the amplifiers to settle at a new value before a new measurement commences.

The signal from each channel is attenuated and level shifted to bring the peak-to-peak signal in to the appropriate range for the 3.3 Volt, 10-bit analogue-to-digital converter of the microcontroller.

Each channel is low-pass analogue filtered with a 2 pole active filter to remove any harmonics above 3.1 KHz. This frequency is chosen so that negligible attenuation is brought about on the 7th and 9th harmonics of the fundamental frequency of the signal for later harmonic analysis.

The sinusoidal signal from the current transformers is sampled at 12.8 KHz. This sampling frequency is chosen because it enables capture of 256 samples over one cycle of the 50 Hz mains waveform.

Digital filtering is performed once the signal is sampled. Digital filtering is desirable at this stage: the peak signal-to-noise ratio is approximately 54dB, as some broadband noise is present on the signal presented to the inputs of the microcontroller; additionally, some high frequency signals are induced by the DC-DC converters on the board. Within the microcontroller a single pole Exponentially Weighted Moving Average Filter (EWMA) reduces any high frequency noise that the signals might have acquired on the modular branch circuit monitor.

To measure the signal the 256 samples of the processed signal are summed to establish the area under the curve. To establish the current consumption the resultant area value is multiplied by a factory calibration. This value is added to an array of collected current measurements to be used for averaging. The averaged current consumption is stored to Modbus registers.

With the oversampling the noise is reduced, resulting in the coherent signal from the continuous-time channel being measured to an accuracy of 2 in 10,000 (equivalent to -74dB) RMS noise. The modular branch circuit monitor resolves to an accuracy of 20 mA in a full scale range of 100 A.

Once a new current value has been established, this is multiplied by a user-configured voltage to establish the instantaneous power consumption (in Watt or kilowatt). The instantaneous power consumption is saved to Modbus registers. Additionally, a cumulative record is kept of the power consumption, alongside a value quantifying the cumulative power consumption of the foregoing half hour.

Instead of referring to a user-configured voltage parameter, the system may include a module for monitoring voltage (as described in more detail below). In this case, the actual measured voltage can be reported to the modular branch circuit monitors.

To enable even better accuracy in calculation of the power consumption, the phase difference between the actual voltage and current (which may deviate from the ideal situation with voltage and current perfectly in phase) may be determined by means of the module for monitoring voltage. A method of synchronising a time reference so that the actual phase difference between the voltage and current can be determined is described in more detail below.

A power factor quantifies the effect of the phase difference between voltage and current on the real power consumption. Assuming perfectly sinusoidal waveforms, the power factor PF is:

$$PF = \cos \varphi$$

where $\varphi$ is the phase difference between voltage and current (this may be determined using a phase counter as discussed in more detail below). The real (instantaneous) power RP is:

$$RP = PF \times V \times I$$

where V is the voltage and I is the current. Taking the power factor into account enables more accurate calculation of real power consumption.

To enable determination of the power factor, the modular branch circuit monitors are supplemented by a modular voltage monitor. The modular voltage monitor detects the voltage signal and communicates it to the modular branch circuit monitors in order for the modular branch circuit monitors to be able to determine the phase difference between the current signal and the voltage signal.

Rather than each current board having the ability to measure the amplitude and phase of voltages and currents, the voltage information can be measured by a single central modular voltage monitor and communicated to all modular branch circuit monitors.

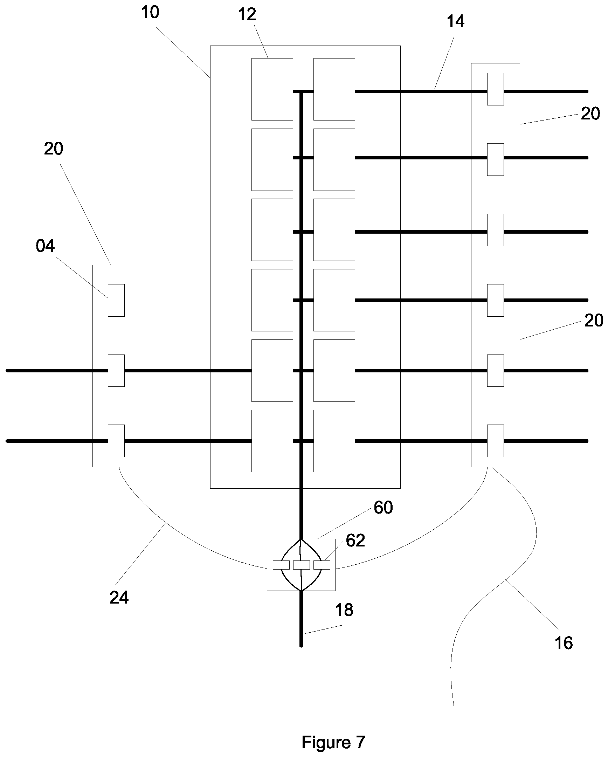

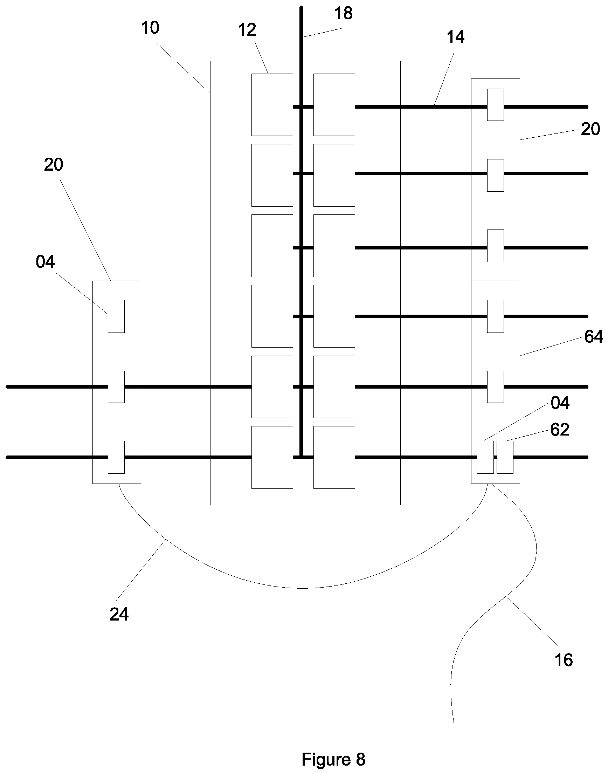

Figures 7 and 8 show examples of a system with modular branch circuit monitors 20 and a modular voltage monitor 60. In the example illustrated in Figure 7, the modular voltage monitor 60 has a voltage detector 62, with which it measures voltage. The modular voltage monitor 60 is positioned at the main power line 18 and connected by data cables 24 to the modular branch circuit monitors 20. The communication between the modules, including between the modular voltage monitor 60 and the modular branch circuit monitors 20, uses the Modbus protocol. The modular voltage monitor 60 includes on-board signal processing (using a processor or microcontroller with associated memory), akin to the modular branch circuit monitors 20. In particular, the modular voltage monitor 60 may include means for voltage reduction, data acquisition, analogue-to-digital conversion, sampling, filtering, and/or signal analysis.

In Figure 7 three voltage detectors 62 are shown, which are used to detect the voltage carried in the three circuit conductors of a three-phase power line. In case the main power line 18 to the electrical distribution board 10 is a single-phase power line, then a single voltage detector may be provided to detect the voltage carried in the circuit conductor. To measure the voltage, a circuit conductor is typically wired (parallel to the power line) directly onto terminals on the modular voltage monitor 60 and stepped down to be measured by a detector 62.

In the example illustrated in Figure 8 the modular voltage monitor is a combined modular voltage / branch current monitor 64. It carries - like the other modular branch circuit monitors 20 - branch current detectors 04; in addition, a voltage detector 62 is included, from which voltage measurements are supplied to the other modules.

The arrangement with a combined modular voltage / branch current monitor (as seen in Figure 8) is suitable for a single-pole distribution board, where all branches have the same phase. In a three-pole distribution board, the arrangement with a dedicated modular voltage monitor (as seen in Figure 7) positioned at the main power line 18 enables convenient detection of all three phases.

The modular voltage monitor measures voltage information (voltage amplitude and voltage phase information) and communicates it to all modular branch circuit monitors. This allows separation of voltage measurement from current measurement. As there are only few (usually three) channels of voltage information to be collected, whereas there can be hundreds of current channels to be measured, this allows elimination of redundant measurement capability, and can thereby allow efficiency of applied resources and reduction of costs.

The arrangement with a combined modular voltage / branch current monitor (as seen in Figure 8) can provide a simpler system with easier installation.

The arrangement with a dedicated modular voltage monitor (as seen in Figure 7) can provide better overall system accuracy. By having a modular voltage monitor dedicated to only measuring voltage amplitude and voltage phase, the voltage measurement hardware need do only one set of measurements to a high degree of accuracy, rather than having to carry out the multiple, disparate tasks that would be involved if the voltage measurement were part of the branch monitoring hardware.

The arrangement with a dedicated modular voltage monitor may also have benefits with respect to safety considerations. Since dangerous voltages are present on the voltage phases, measuring the voltages separately and communicating the voltage information to the modular branch circuit monitors (potentially even by opto-isolated communications) increases safety for the users and service personnel.

To ensure that the modular system achieves high accuracy, it is important that the communication between the modular voltage monitor and the modular branch circuit monitors occurs with high integrity.

The communication between the modular voltage monitor and other devices is across the Modbus, a relatively slow medium that typically carries data at between 9600 and 115,200 bits per second. This data is 'asynchronous' in that messages can be sent and received at any time without reference to a master, system-wide clock. This is normally sufficient for routine communications. If however for example there is a substantial lag in communicating an instantaneous phase value, then the lag itself may incorrectly be attributed to the phase, and introduce errors.

A detection, communication and synchronisation procedure as is described below is designed to ensure that the communication is efficient and accurate.

As described above, one or more modular branch circuit monitors and a modular voltage monitor are connected to one another in a network. The communication links between the modules use the Modbus communication protocol. To ensure efficient and accurate communication, the modular voltage monitor communicates a signal to the modular branch circuit monitors on detection of the occurrence of an event that marks a point of reference in the voltage waveform. The event is advantageously a zero-crossing of the voltage, which may enable the phase to be accurately distinguished and detected. The modular branch circuit monitors receiving the signal are triggered by the signal to synchronise to the detected phase. To ensure that minimal delays occur, an alerting signal precedes and initiates detection, communication and synchronisation to the detected phase, and sets the modular branch circuit monitors into a state of readiness. From the state of readiness, receipt of the communication from the modular voltage monitor immediately triggers synchronisation to the detected phase.

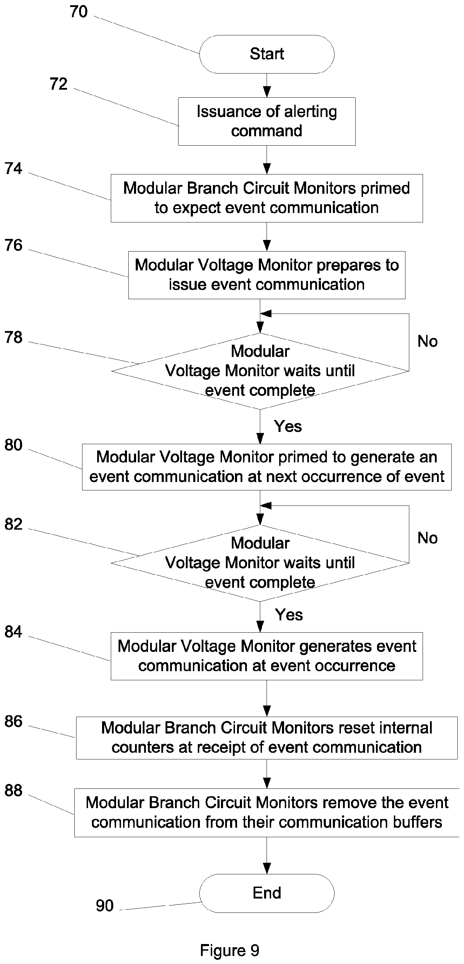

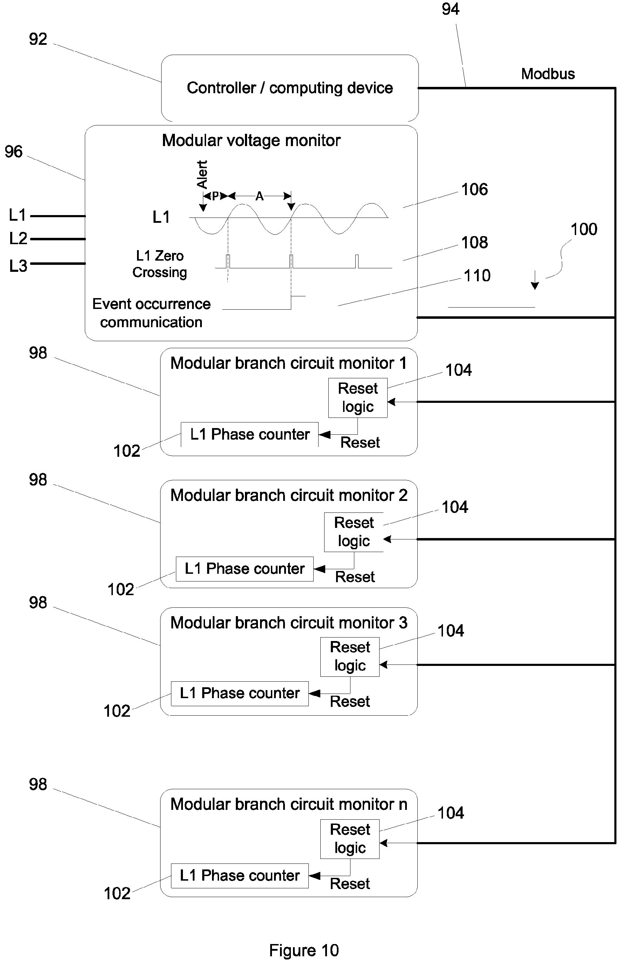

Figure 9 is a flow diagram of the detection, communication and synchronisation procedure. Figure 10 is a schematic diagram of the phase synchronisation. Briefly, the modular voltage monitor waits until a first zero-crossing is detected, then enters an active state in which the detection of a second zero-crossing triggers an event communication.

With reference to Figure 9, following issuance of an alerting command 72, the modular branch circuit monitors are primed to expect an event communication 74. Also, the modular voltage monitor prepares to issue event communication 76. To do so, the modular voltage monitor waits until the current or on-going wave period is completed 78; with respect to a zero-crossing event, it waits until the next zero-crossing occurs. Thereafter, the modular voltage monitor is primed to generate an event communication at the next following occurrence of the event 80. The modular voltage monitor waits until the next event (zero-crossing) is complete 82 and immediately thereafter generates event communication 84 to the network. Meanwhile, the modular branch circuit monitors have been awaiting the event communication in a state of readiness. On receipt of the event communication, the modular branch circuit monitors reset their internal counters 86, and thus become synchronised to the detected voltage phase. Following synchronisation, the modular branch circuit monitors may remove the event communication from their communication buffers 88.

The sine-shaped signal has two zero-crossings in each wave period: one with positive gradient at the crossing, and the other with negative gradient at the crossing. In the example illustrated here only the zero-crossings with positive gradients are used. Alternatively only zero-crossings with negative gradients may be used, or zero-crossings regardless of gradients.

Figure 10 shows a system interface 92 (or computing device or controller or other interfacing device) that issues the alerting command and initiates the synchronisation procedure. The system interface 92 is connected by a communication link 94 (using the Modbus communication protocol) to a modular voltage monitor 96 and a number of modular branch circuit monitors 98. The modular voltage monitor 96 monitors the voltage levels and voltage phases of three voltage inputs: L1, L2, and L3, the three lines of a three-phase power supply as mentioned above).

The modular voltage monitor 96 detects occurrence of zero-crossing events, in the illustrated example for the L1 voltage input. It generates an event communication output 100 that is communicated to the modular branch circuit monitors 98 to allow them to synchronise with the zero-crossing of a selected phase (L1 in the illustrated example). Each modular branch circuit monitor 98 has a free running phase counter 102 running within the processor. On receipt of the synchronisation communication, each modular branch circuit monitor 98 synchronises (for a zero-crossing event: resets) its phase counter 102 by means of a reset logic 104. The free running phase counter 102 is used to reference the phase relationship between the line voltages (L1 in the illustrated example) and the measured currents. Knowing this relationship allows modular branch circuit monitors 98 to calculate the phase difference, and therewith (using the collected current measurements) the real power.

By using dedicated hardware for the detection, communication and synchronisation procedure the timing integrity is maintained for measurements that are communicated around the system. Latencies present in a normal Modbus (or other similar) communication protocol are minimised by the detection, communication and synchronisation procedure. This allows using Modbus lines 94 to carry time-critical information, such as the zero-crossing information of a selected phase.

An example of the detection, communication and synchronisation procedure is now described in more detail and with reference to Figures 9 and 10.

The modular voltage monitor 96 is designed to monitor the voltage levels and relative phases of three voltage inputs L1, L2, L3. Each of the three voltage input lines is an approximation of a 250 Volt RMS sine wave with a frequency of 50 Hertz and with the phase of each line offset from each other by 120 degrees. The modular voltage monitor 96 operates autonomously and responds to Modbus requests with the requested information. The modular voltage monitor 96 can measure and report data including the following:

- L1 Phase RMS Voltage
- L2 Phase RMS Voltage
- L3 Phase RMS Voltage
- Power Grid Frequency
- L1, L2, L3 relative phase
- Zero Crossing Pulse
- L1 Voltage Harmonic Content
- L2 Voltage Harmonic Content
- L3 Voltage Harmonic Content

The modular voltage monitor 96 can select and monitor any one of the three phases for various measurements. Optionally, the Zero Crossing Pu!se is monitored to improve measurement accuracy, as is described in more detail below. These data can be communicated across the Modbus lines 94 in the normal manner, for example to the system interface 92.

In addition to carrying out measurement tasks, the modular voltage monitor 96 is able to monitor every zero-crossing of any one of the connected voltage phases. The modular voltage monitor 96 is designed to carry out a special function where it generates an output to allow modular branch circuit monitors 98 to synchronise with the zero-crossing of a selected phase. The output is a special event communication signal that is routed directly to the Modbus line 94. The event communication signal is a single pulse or step that occurs at the 'zero-crossing' of the selected phase. This 'zero-crossing' occurs when the voltage signal equals (or is sufficiently close to) 0 Volts. This pulse position of the Zero Crossing Pulse is affected, to a small extent, by the frequency and amplitude of the line phase that is input to the Zero Crossing Detector circuit. To allow the modular branch circuit monitors 98 to be able to correct for any error in the Zero Crossing Detector Circuit, the relative phase of the Zero Crossing Pulse is measured with respect to the 3 power phases, L1, L2 and L3 with a record taken of which phase is driving the Zero Crossing Detector circuit. Since the relative phase measurements are gathered at the same time, the error of the Zero Crossing Detector is known and can be communicated to the modular branch circuit monitors 98.

Within the modular branch circuit monitors 98, the error of the Zero Crossing Detector circuit on the modular voltage monitor 96 can be corrected for, thus cancelling out variations in the Zero Crossing Pulse brought about by varying voltage or frequency on the input phase driving the Zero Crossing Detector circuit.

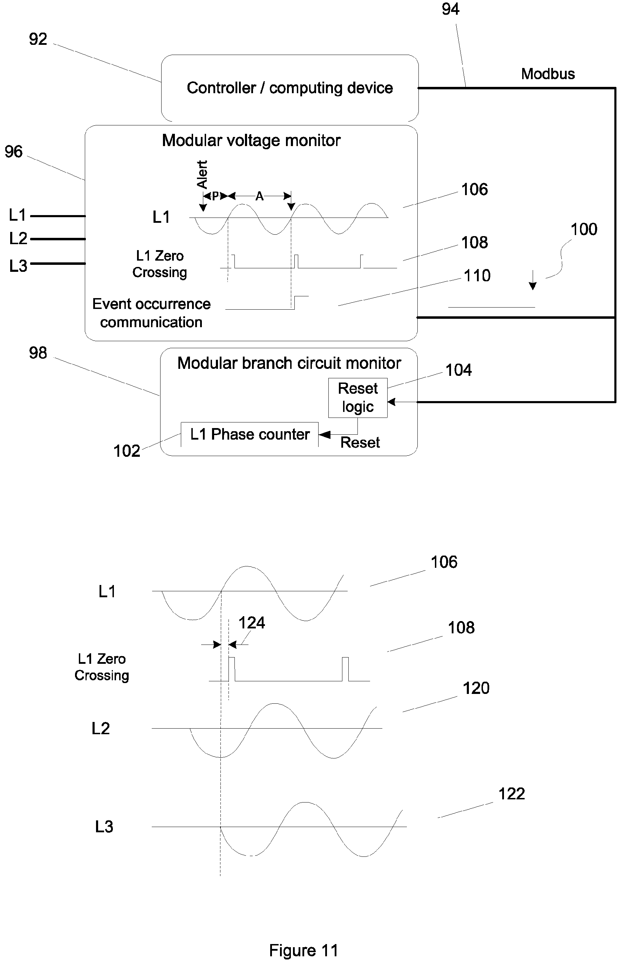

Figure 11 illustrates the measurement error within a Zero Crossing Detector circuit in more detail. In the lower part of the figure, an enlarged view of a realistic, non-ideal zero-crossing pulse 108 is shown, with a zero-crossing error 124 in the time of the (measured) zero crossing 108. The zero-crossing detection point can vary in dependence on the amplitude and frequency of the signal driving it. For example, if the driving power line 106 (in the illustrated examples L1) changes amplitude or frequency, it is observed that the zero crossing can vary by up to plus or minus 10 degrees.

For correction of the zero-crossing error a 2-dimensional correction table can be created by testing the board, allowing characterisation of the error of the zero-crossing detector at a range of voltages and frequencies. Use of this calibration table requires interpolated lookup and a complex algorithm to be useful.

Instead of using a correction table, the zero-crossing error 124 (or relative phase) of the zero-crossing pulse 108 is measured at the same time as the three power lines L1, L2 and L3 106 120 122. At the modular voltage monitor 96, the occurrence of a zero-crossing event is communicated to the modular branch circuit monitors 98 with a low-latency communication link, as described in more detail below. The zero-crossing pulse 108 is known to have an error. At the same time, the modular voltage monitor 96 measures with high accuracy, but not as part of the low latency communication link, the three power lines L1, L2 and L3. By comparing the zero-crossing pulse 108 with the driving power line 106 (in the illustrated example L1), the actual zero-crossing error 124 becomes known. The actual zero-crossing error 124 is communicated by a standard communication to the branch boards, which can then apply the correction to the zero-crossing pulse 108 that was received. Thereby it is possible to correct a zero-crossing error 124 at the modular branch circuit monitors 98, and enable accurate calculation of power at the modular branch circuit monitors 98.

As there are typically three power lines L1, L2 and L3 106 120 122 at different phases relative to one another, and as at a given modular branch circuit monitor 98 any one of the possible power lines may be in use, a set of correction values, one for each possible power line, is communicated.

By the correction of errors in the zero-crossing pulse 108 as described above the system can maintain a high level of accuracy, even if the individual monitor boards are subject to drift or settling throughout their lifetime; the correction can also enable accuracy despite an external influence such as an environmental condition. As the correction does not rely on board calibration for a particular drive frequency or amplitude, there is no dependency on the exact calibration conditions.

The process of communicating the zero-crossing to the modular branch circuit monitors 98 is initiated by the system interface 92 issuing a special alerting command (marked 'Alert' in Figure 10). The alerting command is a string of binary data sent serially (according to the Modbus protocol) along the Modbus lines 94. This command initiates synchronisation and sets the modular voltage monitor 96 in a primed state and the modular branch circuit monitors 98 in a state in readiness of synchronisation. In the preferred embodiment synchronisation only occurs approximately once a second in order to maintain high accuracy of the calculated real power without clock drift becoming significant.

In the primed state (marked 'P' in Figure 10), the modular voltage monitor 96 monitors (using a software loop running on the processor) the selected phase 106 and waits until it sees a zero-crossing event 108. The monitoring may be part of its normal monitoring. The selected phase is usually phase L1, since this is the phase that serves as the reference phase for other measurements. The modular voltage monitor 96 waits in this loop until it sees that a zero-crossing has completed. When a zero-crossing event is completed the modular voltage monitor 96 goes on to enter an active state (marked 'A' in Figure 10), in which dedicated on-board logic hardware is enabled to route 110 the next zero-crossing signal directly to the Modbus communication line 94. The reason the modular voltage monitor 96 waits for the end of a zero-crossing (instead of directly communicating the zero-crossing) is to ensure that when the next zero-crossing occurs, there need be no processor interaction and risk of introducing delays. In this manner the zero-crossing circuit drives the Modbus line 94 directly and without any delays or latency.

In the active state the modular voltage monitor 96 enables a hardware logic circuit that passes the next full zero-crossing pulse directly to a hardware circuit that issues an event communication to the Modbus line 94. In this manner dedicated, autonomous hardware on the modular voltage monitor 96 passes the zero-crossing event directly on to the Modbus communication line 94. At the Modbus line 94 an event communication is issued in the form of an 'active' binary state for the length of one single Modbus character (equivalent to the 'Null' character '00'). The modular voltage monitor 96 persists in the active state for 20 milliseconds, and if no event occurs within this time, then normal operation is resumed.

The modular branch circuit monitors 98 have, inside their microprocessor, a continuously running 32 bit internal phase counter 102. The value of the counter 102 indicates the voltage phase of the primary power supply (usually L1) connected to the system. During normal operation the modular branch circuit monitors 98 listen for the special alerting command. When this command is seen, the modular branch circuit monitors 98 enter a state of readiness, in particular a hardware state, in which they expect a zero-crossing event communication.

Each modular branch circuit monitor 98 primed in its state of readiness detects the 'active' binary state representing the synchronisation event communication on the Modbus line 94, and in response its processor resets its internal phase counter 102 to zero. In other words, when primed in the state of readiness the next 'edge' of the data present on the Modbus line 94 causes the internal phase counter to be reset to zero. More specifically, the state of readiness allows the next change of binary state on the Modbus line 94 to interrupt the modular branch circuit monitor processor with a primary level interrupt, causing the microprocessor to reset the 32 bit counter 102. In this manner the processor responds with extremely small and predictable latency to the change of binary state on the Modbus line 94. Thus, the counter 102 is synchronized with the zero-crossing of the primary voltage phase.

The modular branch circuit monitors 98 continue to carry out measurements while they are in the state of readiness, but they are configured to carry out actions on the edge of the change of binary state on the Modbus line 94 with high priority. The modular branch circuit monitors 98 remain in the state of readiness for up to 45 milliseconds before returning to their normal operating state. The 45ms duration of the state of readiness is chosen because it can accommodate two full cycles of the mains that is running at 50 Hertz (2 x the period of 20 ms plus a margin of 5 ms = 45 ms). In the absence of receipt of an event communication within the window, or after resetting of the internal phase counter 102, the modular branch circuit monitors 98 then return to normal operation, receiving requests and generating replies. For routine current measurements made by the modular branch circuit monitor 98, the value of the counter 102 can be used to indicate the exact phase of the voltage lines to a high degree of accuracy.

Once the modular branch circuit monitors 98 resume normal operation they treat the event communication as a 'Null' character ('00') on the Modbus and remove it from their Modbus communication buffer.

The system interface 92 receives and ignores the event communication as it appears in the Modbus communication buffer as a 'Null' character ('00').

After the counter of a modular branch circuit monitor is synchronized with the zero-crossing of the primary voltage phase, the modular branch circuit monitor can calculate the real power at the module and pass real power data on to the system interface (or controller or computing device) for storage, display and evaluation.

The instantaneous phase between the current and the voltage is calculated on the modular branch circuit monitor by referring to the instantaneous value of the internal phase counter 102 (also referred to a local phase clock). In addition, the period of the sine wave is required. Determination of the period is described in more detail below. The modulo of the instantaneous phase counter value divided by the period quantifies the instantaneous phase. As used herein, the modulo is the fractional (non-integer) part of the real-number result of the division.

The phase counter (which represents the voltage waveform, as it was synchronised with a zero-crossing of the voltage) for example operates at 10,000,000 Hz and the period is 200,000 counts. If the phase counter has an instantaneous value of 900,000 (taken at the instant a current measurement has finished), then dividing the counter value by the period value give a result of 4.5. The modulo (here: 0.5) indicates the proportion of a full 360 degree cycle that the voltage waveform is at when that current measurement is taken. The value in this example is 0.5 which indicates 360 * 0.5 = 180 degrees.

The phase of the current signal is also required to determine the phase difference between the phase of the measured current waveform and the phase of the voltage waveform. Provided the current measurement samples the current signal at a sufficient frequency, the instantaneous phase of the measured current waveform can be determined with high precision. This allows accurate calculation of the phase difference between the current and voltage in the branch monitor.

As described above, the power factor is a cosine function of the phase difference between the current and voltage waveforms. Once the phase difference is determined, the power factor is determined by accessing a sine wave look-up table. The modular branch circuit monitor has a suitable look-up table in its local memory. Once the power factor is determined, the real power is calculated, using the voltage amplitude obtained from the voltage board and the measured current.

As mentioned, the calculation of the instantaneous phase difference between the current and the voltage requires determination of the wave period (or frequency, the frequency being the inverse of the period). In one example, the period is determined from the current data measured on the modular branch circuit monitor.

In another example the period is determined at the modular voltage monitor from the voltage data measured there, and the period information is communicated to the modular branch circuit monitor. To measure the period the processor on a module has a period counter that measures the time between 2 successive zero-crossings (with the same gradient orientation) of a voltage phase. For example in the case of a 50 Hz waveform and with a clock frequency of 10,000,000 Hz, then a period has a duration of 10,000,000 / 50 = 200,000 counts. This value is communicated as a standard message across the Modbus communication line informing the modular branch circuit monitors that the period is 200,000 counts.

This method of determining the period has a disadvantage relating to clock variations. Each board in the system uses its own clock. Although the clocks are typically very accurate, they are not infinitely accurate, and the different clocks are not exactly the same. For example, two modules with clocks with a nominal frequency of 10,000,000 Hz and an accuracy of 30 parts per million can have an actual frequency of 10,000,300 Hz on one module, while the other module has an actual frequency of 9,999,700 Hz. Similarly a period that on one module has a duration of 200,010 counts has - on the other module - a period of 199,990 counts. Hence if the modular voltage monitor reports a period - of for example 200,000 counts - to a modular branch circuit monitor with a clock running slightly faster or slower, an error can be introduced in the period value, in the illustrated example +/- 10 counts.

To overcome the disadvantage relating to clock variations in a further example the period is determined at the modular branch circuit monitor, using the local clock, from signals transmitted from the modular voltage monitor in response to voltage measurements. An arrangement to extend the synchronisation method so as to enable determination of the period at the modular branch circuit monitor is now described in more detail.

As described above, the synchronisation method uses the Modbus communication line to communicate time-critical information. The same arrangement is extended to measure the period (and/or frequency) of the voltage waveform. The same hardware is used, with no changes necessary.

At the modular voltage monitor, instead of measuring the time between two successive zero-crossings of a voltage phase, the zero-crossings cause the modular voltage monitor to issue a signal to the Modbus line. The issuing of a signal follows the same procedure as the synchronisation signal. Each modular branch circuit monitor receiving the signal stores two successive snapshots of the value of its clock (rather than resetting the phase counter as with the synchronisation command described above). The period is the difference between the two time stamps. As with the synchronisation, the period signal may cause an interrupt at the modular branch circuit monitor processor with a primary level interrupt, causing the microprocessor to store a period start timestamp and a period end timestamp. Instead of using time stamps, a period counter could be reset to zero at the first signal, and stopped at the second signal.

By collecting critical data (including instantaneous current amplitude and phase, instantaneous voltage phase and period) locally and calculating the real power locally each module measures to its maximum accuracy, and errors introduced due to not all clocks running at exactly the same rate can be minimised.

In the preferred embodiment determination of the period occurs approximately once a second in order to maintain high accuracy of the calculated real power without clock drift becoming significant.

In some examples the modular branch circuit monitor supplies more data than just the real power, and the system interface undertakes some further calculations with the data. Alternatively, the modular branch circuit monitor may supply current data to the system interface, while the modular voltage monitor supplies voltage data to the system interface, allowing the power calculation to be made by the system interface.

In a daisy chain arrangement where modules connect serially one to another, data passes through a communication channel on the modules. In this way the modules are physically connected to one another and form a network. Data from a first module may pass through a second module without the second module requiring or making use of the data from the first module. The network arrangement at the same time enables the modules to share data, as in the case of the synchronisation described above.

It will be understood that the present invention has been described above purely by way of example, and modifications of detail can be made within the scope of the invention as claimed.

**Claims**

1. A method of synchronising first and second measurement modules (96), (98) measuring characteristics of respective first and second electrical connections, comprising:

   at the first measurement module (96), detecting a synchronisation event (108) in a measured signal from the first connection (106), the synchronisation event marking a point of reference in said measured signal; in response to detection of the synchronisation event (106), transmitting a synchronisation signal (100) to the second measurement module (98); and synchronising the second measurement module (98) to the measured signal based on the synchronisation signal (100).

2. A method according to Claim 1, wherein the synchronisation event (108) corresponds to the value of the measured signal meeting a predetermined criterion.

3. A method according to Claim 1 or 2, wherein the first measurement module (96) is adapted to measure a voltage of the first connection (106) and/or wherein the second measurement module (98) is adapted to measure a current of the second connection.

4. A method according to Claim 3, wherein the synchronisation event (108) corresponds to a zero-crossing of the (or a) measured voltage of the first connection (106).

5. A method according to any preceding claim, further comprising detecting a priming event in the measured signal prior to the synchronisation event (108).

6. A method according to Claim 5, wherein the priming event corresponds to a first zero-crossing detected in the measured signal, and wherein the synchronisation event (108) corresponds to a second zero-crossing detected in the measured signal after the first zero-crossing event.

7. A method according to any preceding claim, comprising, in response to receipt of the synchronisation signal (100) at the second measurement module (98), triggering an interrupt at the second measurement module (98) to process the synchronisation signal (100) and/or perform the synchronising step..

8. A method according to any preceding claim, wherein synchronising the second measurement module (98) comprises resetting a counter (102) at the second measurement module (98).

9. A method according to Claim 8, wherein the counter (102) is a phase counter synchronised to a phase of the signal measured at the first measurement module (96).

10. A method according to any preceding claim, further comprising:

    detecting a further event in the measured signal from the first connection (106); in response to detection of the further event, transmitting a further signal to the second measurement module (98); and

recording at the second measurement module (98) occurrence of the further event.

11. A method according to any preceding claim, wherein the synchronisation signal (100) is transmitted to a plurality of second measurement modules (98).

12. A method according to any preceding claim, further comprising transmitting a correction signal to the second measurement module (98); and correcting the synchronisation of the second measurement module (98) based on the correction signal.

13. A system for synchronising first and second measurement modules (96), (98) measuring characteristics of respective first and second electrical connections, comprising:

at the first measurement module (96), means for detecting a synchronisation event (108) in a measured signal from the first connection (106), the synchronisation event marking a point of reference in said measured signal; and means for transmitting a synchronisation signal (100) to the second measurement module (98) in response to detection of the synchronisation event (106); and
at the second measurement module (98), means for synchronising to the measured signal based on the synchronisation signal (100).

14. A measurement module (96) comprising:

means for measuring a characteristic of an electrical connection (106);
means for detecting a synchronisation event (108) in a measured signal from the connection (106), the synchronisation event marking a point of reference in said measured signal; and means for transmitting a synchronisation signal (100) to another measurement module (98) in response to detection of the synchronisation event (108).

15. A measurement module (98) comprising:

means for measuring a characteristic of an electrical connection;
means for receiving a synchronisation signal (100) from another measurement module, the synchronisation signal being transmitted in response to a detection of a synchronisation event in said another measurement module, the synchronisation event marking a point of reference in said measured signal; and
means for generating output data based on the measured characteristic and the synchronisation signal (100).

**Patentansprüche**

1. Verfahren zum Synchronisieren eines ersten und zweiten Messmoduls (96), (98), die Merkmale einer jeweiligen ersten und zweiten elektrischen Verbindung messen, umfassend:

an dem ersten Messmodul (96) Erfassen eines Synchronisationsereignisses (108) in einem Messsignal von der ersten Verbindung (106), wobei das Synchronisationsereignis einen Referenzpunkt in dem Messsignal kennzeichnet;
als Reaktion auf das Erfassen des Synchronisationsereignisses (106) Übertragen eines Synchronisationssignals (100) zu dem zweiten Messmodul (98), und
Synchronisieren des zweiten Messmoduls (98) mit dem Messsignal basierend auf dem Synchronisationssignal (100).

2. Verfahren nach Anspruch 1, wobei das Synchronisationsereignis (108) dem Wert des Messsignals, der ein vorbestimmtes Kriterium erfüllt, entspricht.

3. Verfahren nach Anspruch 1 oder 2, wobei das erste Messmodul (96) angepasst ist, um eine Spannung der ersten Verbindung (106) zu messen und/oder das zweite Messmodul (98) angepasst ist, um einen Strom der zweiten Verbindung zu messen.

4. Verfahren nach Anspruch 3, wobei das Synchronisationsereignis (108) einem Nulldurchgang der (oder einer) gemessenen Spannung der ersten Verbindung (106) entspricht.

5. Verfahren nach einem der vorhergehenden Ansprüche, das ferner das Erfassen eines Vorbereitungsereignisses in dem Messsignal vor dem Synchronisationsereignis (108) umfasst.

6. Verfahren nach Anspruch 5, wobei das Vorbereitungsereignis einem ersten Nulldurchgang entspricht, der in dem Messsignal erfasst wird, und wobei das Synchronisationsereignis (108) einem zweiten Nulldurchgang entspricht, der in dem Messsignal nach dem ersten Nulldurchgangsereignis erfasst wird.

7. Verfahren nach einem der vorhergehenden Ansprüche, das als Reaktion auf das Empfangen des Synchronisationssignals (100) an dem zweiten Messmodul (98) das Auslösen eines Interrupt an dem zweiten Messmodul (98) umfasst, um das Synchronisationssignal (100) zu verarbeiten und/oder den Synchronisationsschritt auszuführen.

8. Verfahren nach einem der vorhergehenden Ansprüche, wobei das Synchronisieren des zweiten Messmoduls (98) das Rückstellen eines Zählers (102) an dem zweiten Messmodul (98) umfasst.

9. Verfahren nach Anspruch 8, wobei der Zähler (102) ein Phasenzähler ist, der mit einer Phase des Signals, das an dem ersten Messmodul (96) gemessen wird, synchronisiert ist.

10. Verfahren nach einem der vorhergehenden Ansprüche, ferner umfassend:

   Erfassen eines weiteren Ereignisses in dem Messsignal von der ersten Verbindung (106); als Reaktion auf das Erfassen des weiteren Ereignisses, Übertragen eines weiteren Signals zu dem zweiten Messmodul (98), und an dem zweiten Messmodul (98) Aufzeichnen des Auftretens des weiteren Ereignisses.

11. Verfahren nach einem der vorhergehenden Ansprüche, wobei das Synchronisationssignal (100) zu einer Vielzahl zweiter Messmodule (98) übertragen wird.

12. Verfahren nach einem der vorhergehenden Ansprüche, das ferner das Übertragen eines Korrektursignals zu dem zweiten Messmodul (98) umfasst, und das Korrigieren der Synchronisation des zweiten Messmoduls (98) basierend auf dem Korrektursignal.

13. System zur Synchronisation eines ersten und zweiten Messmoduls (96), (98), die Merkmale einer ersten und zweiten elektrischen Verbindung messen, umfassend:

   an dem ersten Messmodul (96) Mittel zum Erfassen eines Synchronisationsereignisses (108) in einem Messsignal von der ersten Verbindung (106), wobei das Synchronisationsereignis einen Referenzpunkt in dem Messsignal kennzeichnet, und Mittel zum Übertragen eines Synchronisationssignals (100) zu dem zweiten Messmodul (98) als Reaktion auf das Erfassen des Synchronisationsereignisses (106), und an dem zweiten Messmodul (98) Mittel zum Synchronisieren des Messsignals basierend auf dem Synchronisationssignal (100).

14. Messmodul (96), umfassend:

   Mittel zum Messen eines Merkmals einer elektrischen Verbindung (106); Mittel zum Erfassen eines Synchronisationsereignisses (108) in einem Messsignal von der Verbindung (106), wobei das Synchronisationsereignis einen Referenzpunkt in dem Messsignal kennzeichnet, und Mittel zum Übertragen eines Synchronisationssignals (100) zu einem anderen Messmodul (98) als Reaktion auf das Erfassen des Synchronisationsereignisses (108).

15. Messmodul (98), umfassend:

   Mittel zum Messen eines Merkmals einer elektrischen Verbindung; Mittel zum Empfangen eines Synchronisationssignals (100) von einem anderen Messmodul, wobei das Synchronisationssignal als Reaktion auf ein Erfassen eines Synchronisationsereignisses in dem anderen Messmodul übertragen wird, wobei das Synchronisationsereignis einen Referenzpunkt in dem Messsignal kennzeichnet, und Mittel zum Erzeugen von Ausgabedaten basierend auf dem gemessenen Merkmal und dem Synchronisationssignal (100).

## Revendications

1. Procédé de synchronisation de premier et deuxième modules de mesure (96), (98) mesurant des caractéristiques de première et deuxième connexions électriques respectives, comprenant :

   au niveau du premier module de mesure (96), la détection d'un événement de synchronisation (108) dans un signal mesuré provenant de la première connexion (106), l'événement de synchronisation marquant un point de référence dans ledit signal mesuré ; en réponse à la détection de l'événement de synchronisation (106), la transmission d'un signal de synchronisation (100) au deuxième module de mesure (98) ; et la synchronisation du deuxième module de mesure (98) sur le signal mesuré en fonction du signal de synchronisation (100).

2. Procédé selon la revendication 1, dans lequel l'événement de synchronisation (108) correspond à la valeur du signal mesuré satisfaisant à un critère prédéterminé.

3. Procédé selon la revendication 1 ou 2, dans lequel le premier module de mesure (96) est adapté pour mesurer une tension de la première connexion (106) et/ou dans lequel le deuxième module de mesure (98) est adapté pour mesurer un courant de la deuxième connexion.

4. Procédé selon la revendication 3, dans lequel l'événement de synchronisation (108) correspond à un passage par zéro de la (ou d'une) tension mesurée de la première connexion (106).

5. Procédé selon l'une quelconque des revendications précédentes, comprenant en outre la détection d'un événement d'amorçage dans le signal mesuré avant l'événement de synchronisation (108).

6. Procédé selon la revendication 5, dans lequel l'événement d'amorçage correspond à un premier passage par zéro détecté dans le signal mesuré, et dans lequel l'événement de synchronisation (108) correspond à un deuxième passage par zéro détecté dans le signal mesuré après le premier événement de passage par zéro.

7. Procédé selon l'une quelconque des revendications précédentes, comprenant, en réponse à la réception du signal de synchronisation (100) au niveau du deuxième module de mesure (98), le déclenchement d'une interruption au niveau du deuxième module de mesure (98) pour traiter le signal de synchronisation (100) et/ou exécuter l'étape de synchronisation.

8. Procédé selon l'une quelconque des revendications précédentes, dans lequel la synchronisation du deuxième module de mesure (98) comprend la remise à zéro d'un compteur (102) au niveau du deuxième module de mesure (98).

9. Procédé selon la revendication 8, dans lequel le compteur (102) est un compteur de phase synchronisé sur une phase du signal mesuré au niveau du premier module de mesure (96).

10. Procédé selon l'une quelconque des revendications précédentes, comprenant en outre :

    la détection d'un événement additionnel dans le signal mesuré provenant de la première connexion (106) ;
    en réponse à la détection de l'événement additionnel, la transmission d'un signal additionnel au deuxième module de mesure (98) ; et l'enregistrement au niveau du deuxième module de mesure (98) de la survenue de l'événement additionnel.

11. Procédé selon l'une quelconque des revendications précédentes, dans lequel le signal de synchronisation (100) est transmis à une pluralité de deuxième modules de mesure (98).

12. Procédé selon l'une quelconque des revendications précédentes, comprenant en outre la transmission d'un signal de correction au deuxième module de mesure (98) ; et la correction de la synchronisation du deuxième module de mesure (98) en fonction du signal de correction.

13. Système de synchronisation de premier et deuxième modules de mesure (96), (98) mesurant des caractéristiques de première et deuxième connexions électriques respectives, comprenant :

    au niveau du premier module de mesure (96), des moyens de détection d'un événement de synchronisation (108) dans un signal mesuré provenant de la première connexion (106), l'événement de synchronisation marquant un point de référence dans ledit signal mesuré ;
    des moyens de transmission d'un signal de synchronisation (100) au deuxième module de mesure (98) en réponse à la détection de l'événement de synchronisation (106) ; et
    au niveau du deuxième module de mesure (98), des moyens de synchronisation sur le signal mesuré en fonction du signal de synchronisation (100).

14. Module de mesure (96) comprenant :

    des moyens de mesure d'une caractéristique d'une connexion électrique (106) ;
    des moyens de détection d'un événement de synchronisation (108) dans un signal mesuré provenant de la première connexion (106), l'événement de synchronisation marquant un point de référence dans ledit signal mesuré ; et
    des moyens de transmission d'un signal de synchronisation (100) à un autre module de mesure (98) en réponse à la détection de l'événement de synchronisation (108).

15. Module de mesure (98) comprenant :

    des moyens de mesure d'une caractéristique d'une connexion électrique ;
    des moyens de réception d'un signal de synchronisation (100) en provenance d'un autre module de mesure, le signal de synchronisation étant transmis en réponse à une détection d'un événement de synchronisation dans ledit autre module de mesure ; et
    des moyens de génération de données de sortie en fonction de la caractéristique mesurée et du signal de synchronisation (100).

Figure 1

Figure 2

20

04

36

20

30

38-2

38-1

46

Figure 3a

20

04

32

20

30

36

34

Figure 3b

**Figure 4a**

**Figure 4b**

04    20

Module

D1    D2    D3

34

Processor    Memory    Communication module

40

42

D6    D5    D4

44

Figure 5

Figure 6

Figure 7

Figure 8

70 — ( Start )

72 — Issuance of alerting command

74 — Modular Branch Circuit Monitors primed to expect event communication

76 — Modular Voltage Monitor prepares to issue event communication

78 — Modular Voltage Monitor waits until event complete — No

Yes

80 — Modular Voltage Monitor primed to generate an event communication at next occurrence of event

82 — Modular Voltage Monitor waits until event complete — No

Yes

84 — Modular Voltage Monitor generates event communication at event occurrence

86 — Modular Branch Circuit Monitors reset internal counters at receipt of event communication

88 — Modular Branch Circuit Monitors remove the event communication from their communication buffers

( End )
90

Figure 9

Figure 10

Figure 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 03041029 A
- WO 2007063482 A